# EUROPEAN PATENT APPLICATION

(11) **EP 3 716 273 A1**
(43) Date of publication of application: **30.09.2020**
(21) Application number: 20158068.5
(22) Date of filing: 18.02.2020
(51) Int. Cl.: G11C 11/16, H01L 27/22, H01L 43/08, H01L 43/10

(54) **MAGNETIC MEMORY DEVICES AND METHODS OF FABRICATION**

(30) Priority: 27.03.2019 US 201916367122
(71) Applicant: Intel Corporation, Santa Clara, CA 95054-1549 (US)
(72) Inventor: SMITH, Angeline, Hillsboro, Oregon 97124 (US); OUELLETTE, Daniel, Portland, Oregon 97229 (US); WIEGAND, Christopher, Oregon, Portland 97229 (US); BROCKMAN, Justin, Portland, Oregon 97229 (US); RAHMAN, Tofizur, Portland, Oregon 97229 (US); GOLONZKA, Oleg, Beaverton, Oregon 97007 (US); SMITH, Andrew, Hillsboro, Oregon 97123 (US); PELLEGREN, James, Portland, Oregon 97214 (US)
(74) Representative: HGF

(57) **Abstract**

A memory device includes a first electrode, a second electrode and a magnetic junction between the first and the second electrode. The magnetic junction includes a first magnetic structure that includes a first magnet including an alloy of cobalt and tungsten, and a second magnet above the first magnet. The first and the second magnets are separated by a nonmagnetic spacer layer. The magnetic junction further includes a layer including a metal and oxygen on the first magnetic structure. The tunnel barrier layer has an <001> crystal texture. The magnetic junction further includes a third magnet on the tunnel barrier layer. The third magnet has a magnetization which can change in response to torque from a current tunneling through the tunnel barrier layer.

## Description

### BACKGROUND

For the past several decades, feature size reduction has been a key focus for industrial-scale semiconductor process development. Scaling to smaller dimensions enables a higher density of functional elements per chip, smaller chips, and also reduced cost. However, as the industry approaches the physical limits of traditional scaling, it is becoming increasingly important to look for non-traditional types of devices that can offer new functionality. One such example is non-volatile memory based on a perpendicular magnetic tunnel junction (pMTJ).

Non-volatile embedded memory device with pMTJ, e.g., on-chip embedded memory with non-volatility can enable energy and computational efficiency. However, the technical challenges of assembling a pMTJ stack to form functional devices present formidable roadblocks to commercialization of this technology today. Specifically, enhancing tunnel magnetoresistance is one of the challenges in assembling a viable pMTJ stack.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements.
Figure 1A illustrates a cross-sectional view of a memory device, in accordance with an embodiment of the present disclosure.
Figure 1B illustrates a cross-sectional view of a plurality of bilayers including a first magnetic layer, a non-magnetic layer on the first magnetic layer capped by a second magnetic layer on non-magnetic layer.
Figure 1C illustrates a cross-sectional view of a synthetic antiferromagnetic structure, in accordance with an embodiment of the present disclosure.
Figure 2 illustrates a cross-sectional view of a memory device where a fixed magnet structure includes three magnets, in accordance with an embodiment of the present disclosure.
Figure 3 illustrates a flow diagram of a method to fabricate a memory device.
Figure 4A illustrates a conductive interconnect formed above a substrate.
Figure 4B illustrates the structure of Figure 4A following the formation of an electrode layer, formation of a buffer layer on the electrode layer, and formation of a seed layer on the buffer layer.
Figure 4C illustrates the structure of Figure 4B following the formation of layers for a fixed magnet structure.
Figure 4D illustrates a cross-sectional view of the structure in Figure 4C following the formation of plurality of layers in a material layer stack for a memory device.
Figure 4E illustrates a cross-sectional view of the structure in Figure 4D following the patterning of the material layer stack to form a memory device.
Figure 4F illustrates a cross-sectional view of the structure in Figure 4E following the formation of a dielectric spacer adjacent to the memory device.
Figure 5A illustrates a plot of resistance versus magnetic field in a material layer stack for a memory device.
Figure 5B illustrates magnetizations in various magnetic layers in the material layer stack of Figure 5A corresponding to a point A on the plot of Figure 5A.
Figure 5C illustrates magnetizations in various magnetic layers in the material layer stack of Figure 5A corresponding to a point C on the plot of Figure 5A.
Figure 5D illustrates magnetizations in various magnetic layers in the material layer stack of Figure 5A corresponding to a point C' on the plot of Figure 5A.
Figure 5E illustrates magnetizations in various magnetic layers in the material layer stack of Figure 5A corresponding to a point A on the plot of Figure 5A.
Figure 5F illustrates magnetizations in various magnetic layers in the material layer stack of Figure 5A corresponding to a point A' on the plot of Figure 5A.
Figure 6 illustrates a cross-sectional view of a memory device coupled to a transistor.
Figure 7 illustrates a computing device in accordance with embodiments of the present disclosure.
Figure 8 illustrates an integrated circuit (IC) structure that includes one or more embodiments of the present disclosure.

### DESCRIPTION OF THE EMBODIMENTS

Perpendicular-MTJ (pMTJ) devices with enhanced tunnel magnetoresistance ratio factor and methods of fabrication are described. In the following description, numerous specific details are set forth, such as structural schemes and detailed fabrication methods in order to provide a thorough understanding of embodiments of the present disclosure. It will be apparent to one skilled in the art that embodiments of the present disclosure may be practiced without these specific details. In other instances, well-known features, such as transistor operations and switching operations associated with embedded memory, are described in lesser detail in order to not unnecessarily obscure embodiments of the present disclosure. Furthermore, it is to be understood that the various embodiments shown in the Figures are illustrative representations and are not necessarily drawn to scale.

In some instances, in the following description, well-known methods and devices are shown in block diagram form, rather than in detail, to avoid obscuring the present disclosure. Reference throughout this specification to "an embodiment" or "one embodiment" or "some embodiments" means that a particular feature, structure, function, or characteristic described in connection with the embodiment is included in at least one embodiment of the disclosure. Thus, the appearances of the phrase "in an embodiment" or "in one embodiment" or "some embodiments" in various places throughout this specification are not necessarily referring to the same embodiment of the disclosure. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship).

The terms "over," "under," "between," and "on" as used herein refer to a relative position of one component or material with respect to other components or materials where such physical relationships are noteworthy. For example, in the context of materials, one material or material disposed over or under another may be directly in contact or may have one or more intervening materials. Moreover, one material disposed between two materials may be directly in contact with the two layers or may have one or more intervening layers. In contrast, a first material "on" a second material is in direct contact with that second material/material. Similar distinctions are to be made in the context of component assemblies. As used throughout this description, and in the claims, a list of items joined by the term "at least one of' or "one or more of' can mean any combination of the listed terms.

The term "adjacent" here generally refers to a position of a thing being next to (e.g., immediately next to or close to with one or more things between them) or adjoining another thing (e.g., abutting it).

The term "signal" may refer to at least one current signal, voltage signal, magnetic signal, or data/clock signal. The meaning of "a," "an," and "the" include plural references. The meaning of "in" includes "in" and "on."

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

Here, an in-plane magnet refers to a magnet that has magnetization in a direction substantially along the plane of the magnet. For example, a magnet with a magnetization which is in an x or y direction and is in a range of 0 (or 180 degrees) +/- 20 degrees relative to an x-y plane of a device.

The term "free" or "unfixed" here with reference to a magnet refers to a magnet whose magnetization direction can change along its easy axis upon application of an external field or force (e.g., Oersted field, spin torque, etc.). Conversely, the term "fixed" or "pinned" here with reference to a magnet refers to a magnet whose magnetization direction is pinned or fixed along an axis and which may not change due to application of an external field (e.g., electrical field, Oersted field, spin torque,).

As used throughout this description, and in the claims, a list of items joined by the term "at least one of' or "one or more of' can mean any combination of the listed terms. Unless otherwise specified in the explicit context of their use, the terms "substantially equal," "about equal" and "approximately equal" mean that there is no more than incidental variation between two things so described. In the art, such variation is typically no more than +/-10% of a predetermined target value.

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

An MTJ device functions as a memory device where the resistance of the MTJ device switches between a high resistance state and a low resistance state. The resistance state of an MTJ device is defined by the relative orientation of magnetizations between a free magnet and a fixed magnet, that is separated from the free magnet by a tunnel barrier. When magnetizations of the free magnet and the fixed magnet have orientations that are in the same direction, the MTJ device is said to be in a low resistance state. Conversely, when the magnetization of the free magnet and the magnetization of the fixed magnet are oriented in an opposite direction to each other, the MTJ device is said to be in a high resistance state.

As MTJ devices are scaled, the need for smaller memory elements to fit into a scaled cell size has driven the industry in the direction of perpendicular MTJ (pMTJ). pMTJ based memory devices have a fixed magnet and a free magnet each having a magnetic anisotropy that is perpendicular with respect to a horizontal plane of the free magnet. Resistance switching is brought about in a pMTJ device by passing a threshold spin polarized current through the pMTJ device. The spin polarized current can influence the orientation of magnetization in the free magnet, and align the magnetization with or against the magnetization of the fixed magnet. The act of influencing the magnetization is brought about by a phenomenon known as spin torque transfer, where the torque from the spin polarized current (from fixed magnet) is imparted to the magnetization of the free magnet. By changing the direction of the current through the pMTJ, the direction of magnetization in the free magnet may be reversed relative to the direction of magnetization in the fixed magnet. Since the free magnet does not need a constant source of spin polarized current to maintain a magnetization direction, the resistance state of the pMTJ device is retained even when no current flows through the pMTJ device. For this reason, the pMTJ device belongs to a class of memory known as non-volatile memory.

Because a fixed magnet provides for a spin polarized current and remains in a fixed orientation there are challenges for selecting materials for the fixed magnet. Other challenges arise from maintaining and improving perpendicular magnetic anisotropy (PMA) in the fixed magnet to prevent un-intentional changes in magnetization. Improving magnetics (i.e., enhancing perpendicular magnetic anisotropy) in a fixed magnet of a pMTJ stack can improve process margins for bit yield, allow for a higher coercivity switching layer, and provide robustness against loss of switching efficiency from canting of magnetization in fixed magnetic layers and from thermal degradation. Enhancing the PMA of the fixed magnet may be accomplished by inserting additional layers of high-anisotropy multilayers and/or alloys in a fixed magnet structure.

However, addition of magnets also increases magnetic moment of the fixed magnet. Minimizing effects of stray fields in a patterned fixed magnet, while increasing PMA continues to be a challenge. In a discrete memory device including a pMTJ, patterned layers in the pMTJ leads to magnetic stray fields emanating from magnetic layers such as the fixed magnet, for example. Stray fields can impact switching dynamics of the free layer in the pMTJ. High stray fields can cause an offset field on the free layer leading to write errors and device stability issues. Stray fields are directly proportional to a strength of magnetic field in a fixed magnet. The magnetic field, in turn, is dependent on a total magnetic moment of one or more magnetic layers in the fixed magnet. Thus, it is desirable to reduce the total magnetic moment to reduce impact of stray field on memory devices.

The inventors have found that implementing an alloy of a non-magnetic and magnetic material, such as cobalt and tungsten, in a multi-layer stack of magnets can simultaneously improve TMR and lower the magnetic moment. In an embodiment, the multilayer stack includes a first layer that is an alloy of cobalt and tungsten, a layer of non-magnetic material above the alloy and a layer of magnetic material including cobalt, iron and boron on the layer of non-magnetic material. Because the alloy may not have an optimal crystal structure to promote FCC <001> crystal texture, the alloy is distant from the tunnel barrier layer.

In accordance with embodiments of the present disclosure, a memory device includes first electrode and a second electrode and a magnetic junction between the first and the second electrode. The magnetic junction includes a first magnetic structure that includes a first magnet including an alloy of cobalt and tungsten, where the first magnet has a first magnetization and the second magnet having the first magnetization, above the first magnet. The first and the second magnets are separated by a non-magnetic spacer layer. The magnetic junction further includes a layer including a metal and oxygen on the first magnetic structure. In an embodiment, the magnetic junction is a perpendicular magnetic tunnel junction, and the layer including a metal and oxygen is a tunnel barrier. The tunnel barrier has an <001> crystal texture. For improving TMR ratio, the tunnel barrier and the second magnet are highly crystal matched. The magnetic tunnel junction further includes a third magnet on the tunnel barrier. The third magnet has a magnetization which can change in response to torque from a current tunneling through the tunnel barrier.

In perpendicular magnetic tunnel junctions, the fixed magnet has a magnetization that is typically pinned by a magnetization of a second magnet structure (in a direction away from the tunnel barrier). In embodiments, the second magnet structure has a strong PMA where the molecular arrangement is dominated by FCC<111> crystal structure. The presence of the first magnet serves to break the FCC <111> crystal structure of the second magnet structure.

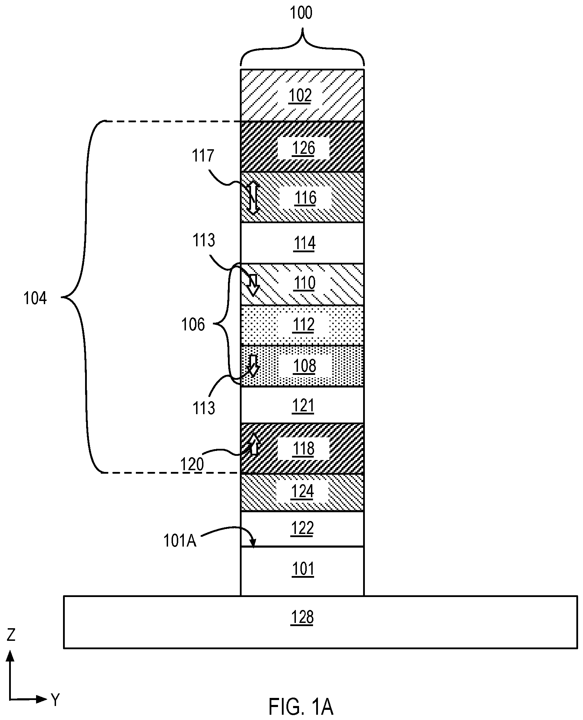

Figure 1A is an illustration of a cross-sectional view of a memory device 100 in accordance with an embodiment of the present disclosure. The memory device 100 includes a first electrode 101, a second electrode 102 above the first electrode 101, and a magnetic tunnel junction (MTJ) 104 between the first electrode 101 and the second electrode 102. In an embodiment, the MTJ 104 is a perpendicular MTJ (pMTJ) 104. The MTJ 104 includes a magnetic structure 106 that has a first magnet 108 including an alloy of cobalt and tungsten and a second magnet 110, above the first magnet 108. The magnets 108 and 110 are separated by a spacer layer 112. Magnets 108 and 112 have a first magnetization 113. The MTJ 104 further includes a layer 114 including a metal and oxygen on the magnetic structure 106 . In the illustrative embodiment, layer 114 is a tunnel barrier 114. In an embodiment, the tunnel barrier has an <001> crystal texture. The MTJ 104 further includes a third magnet 116 on the tunnel barrier 104, where the magnet 116 has a second magnetization 117. The magnetic structure 106 is coupled below by a second magnetic structure 118. The magnetic structure 118 pins the magnetization 113 of the magnetic structure 106.

The magnetic structure 106 has a magnetization 113 that remains fixed during operation. For example, magnetization 113 may orient in the positive or in a negative Z-direction. In the illustrative embodiment, the magnetization 113 is parallel (or antiparallel) to magnetization 117 in the magnet 116. Such a magnetic structure 106 is herein referred to as a fixed magnetic structure 106. The direction of magnetization 113 is perpendicular to a plane of an uppermost surface 101A of the electrode 101. The fixed magnetic structure 106 having a magnetization 113 that is perpendicular to the plane of the uppermost surface 101A may also be known as a perpendicular fixed magnetic structure 106.

The chemical composition of the magnet 108 may be different depending on the embodiment. In an embodiment, the magnet 108 includes a mixture of tungsten and cobalt. In some embodiments, the magnet 108 includes between 1-10 atomic percent of tungsten in the mixture of cobalt and tungsten. The composition of tungsten affects the crystal structure of the magnet 108. In some such embodiments, the balance of the magnet structure 106 is predominantly cobalt. Examples of trace impurities such as C, Si, O and Fe may exist in the alloy, but concentrations may be well below 0.1%. In other embodiments, the conductive layer 122 is no more than 20% tungsten and the balance is substantially cobalt. In one or more embodiments, the conductive layer 122 has a thickness between 0.8 nm and 1 nm.

The chemical composition of the magnet 110 may be different depending on the embodiment. In an embodiment, the magnet 110 includes magnetic materials with sufficient perpendicular magnetization. In an embodiment, the magnet 110 of the MTJ 104 can include alloys such as CoFe, CoFeB, FeB. The alloys of CoFe, CoFeB, FeB may include doping with one or more of Ta, Hf, Mo, Ir, Ru, Si or C, to promote high perpendicular anisotropy. Alternatively, the alloys of CoFe, CoFeB, FeB may include thin layers of Ta or Mo to promote high perpendicular anisotropy. In an embodiment, the magnet 110 comprises a Co_{100-x-y}FeₓB_{y}, where X and Y each represent atomic percent, further where X is between 50-80 and Y is between 10-40, and further where the sum of X and Y is less than 100. In one specific embodiment, X is 60 and Y is 20. In an embodiment, the magnet 110 is FeB, where the concentration of boron is between 10-40 atomic percent of the total composition of the FeB alloy.

In an embodiment, the spacer layer 112 includes tantalum, tungsten or molybdenum. In some embodiments, the spacer layer 112 includes trace amounts (less than 0.1%) of Si, Fe or O. The spacer layer 112 may have a thickness of less than 0.6nm. In some embodiments, spacer layer 112 has a thickness between 0.3nm and 0.5nm. A thickness between 0.3nm and 0.5nm provides interlayer ferromagnetic coupling between the first magnet 108 and the magnet 110.

In an embodiment, tunnel barrier 114 includes a material suitable for allowing electron current having a majority spin to pass through tunnel barrier 114, while impeding, at least to some extent, electron current having a minority spin from passing through tunnel barrier 114. Thus, tunnel barrier 114 (or spin filter layer) may also be referred to as a tunneling layer for electron current of a particular spin orientation. In an embodiment, the tunnel barrier 114 includes a material such as, but not limited to, oxygen and at least one of magnesium (e.g., a magnesium oxide, or MgO), or aluminum (e.g., an aluminum oxide such as Al₂O₃). In the illustrative embodiment, the tunnel barrier 114 including MgO has a crystal orientation that is (001) and is lattice matched to magnet 110 below the tunnel barrier 114 and free magnet 116 above tunnel barrier 114. In an embodiment, a free magnet 116 including a Co_{100-x-y}FeₓB_{y}, is highly lattice matched to the tunnel barrier 114 including an MgO. Lattice matching a crystal structure of the free magnet 116 with the tunnel barrier 114 enables a higher tunneling magnetoresistance (TMR) ratio in the MTJ 104. In an embodiment, tunnel barrier 114 is MgO and has a thickness in the range between 1nm to 2 nm. In exemplary embodiments, where magnets 108 and 116 include CoFeB, MgO is between 0.9nm and 1.1 nm.

The magnet 116 has a magnetization 117 that may change orientation during operation. For example, magnetization 117 may orient in the positive or negative Z-direction as indicated by the bi-directional arrow. Such a magnet 116 is herein referred to as a free magnet 116. The direction of magnetization 117 is perpendicular to a plane of an uppermost surface 101A of the electrode 101. The free magnet 116, having a magnetization 117 that is perpendicular to the plane of the uppermost surface 101A, may also be known as a perpendicular free magnet 116. In an embodiment, when the MTJ 104 includes a perpendicular free magnet 116 and perpendicular fixed magnet structure 106, the MTJ 104 is a pMTJ 104.

In the illustrative embodiment, the free magnet 116 includes a magnetic material such as Co, Ni, Fe or alloys of these materials. In an embodiment, the free magnet 116 includes a magnetic material such as CoB, FeB, CoFe or CoFeB. In some embodiments, the free magnet 116 includes a Co_{100-x-y}FeₓB_{y}, where X and Y each represent atomic percent, further where X is between 50 and 80 and Y is between 10 and 40, and further where the sum of X and Y is less than 100. In one specific embodiment, X is 60 and Y is 20. In an embodiment, the free magnet 116 is FeB, where the concentration of boron is between 10 and 40 atomic percent of the total composition of the FeB alloy. In an embodiment, free magnet 116 has a thickness in the range of 1nm to 1.5nm.

When the direction of magnetization 117 in the free magnet 116 is opposite (anti-parallel) to the direction of magnetization 113 in the fixed magnetic structure 106, the MTJ 104 device is said to be in a high resistance state. Conversely, when the direction of magnetization 117 in the free magnet 116 is parallel to the direction of magnetization 113 in the fixed magnetic structure 106, the MTJ 104 is said to be in a low resistance state.

In an embodiment, the fixed magnetic structure 106 has a higher perpendicular magnetic anisotropy than the free magnet 116 and is more resistant to accidental magnetization flipping. In another embodiment, the magnetization 117 and magnetization 113 are substantially similar. In one such embodiment, an injected spin polarized current which changes the direction of the magnetization 117 in the free magnet 116 can also affect the magnetization 113 of the fixed magnetic structure 106. To prevent an accidental change in the direction of magnetization 113 in during operation, magnetization 113 is pinned by a strong PMA from the magnetic structure 118. In an embodiment, magnetic structure 118 is a pinning structure 118.

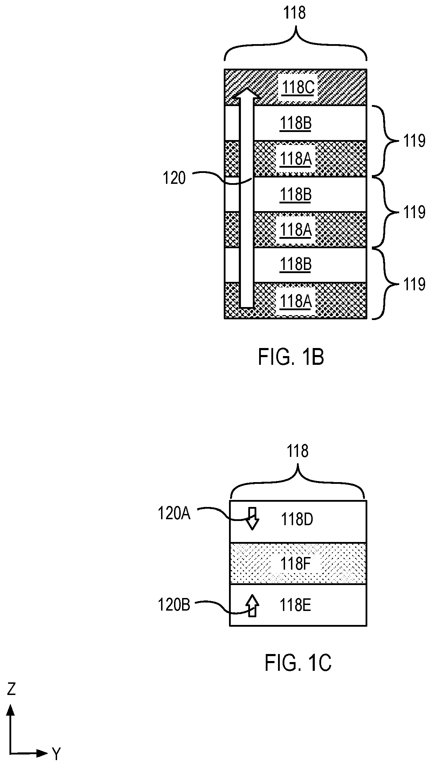

Figure 1B illustrates cross-sectional view of the pinning structure 118 in an accordance of an embodiment of the present disclosure. In an embodiment, pinning structure 118 includes a stack of bilayers 119 where each bilayer includes a layer of magnetic material 118A and a layer of non-magnetic metal 118B on the layer of magnetic material 118A. In an embodiment, the magnetic metal 118B includes Co or Ni and the non-magnetic metal 118B includes Pd, Pt, W or Mo. In an embodiment, the layer of magnetic material 118A has a thickness between 0.2nm and 0.8 nm, and the non-magnetic metal has at thickness between 0.2nm and 0.8 nm. The number of bilayers [put number here] may range between 3-12.

The stack of bilayers 119 is capped by a layer of magnetic material 118C. In an embodiment, 118C includes Co, Ni, CoFeB, CoFe, Fe or FeB. In some embodiments, the layer of magnetic material 118C is the same as layer of magnetic material 118A. In other embodiments, magnetic material 118C is different from the layer of magnetic material 118A. In an embodiment, the layer of magnetic material 118C has a thickness between 3-8 Angstrom. As shown, the pinning structure 118 has a magnetization 120 that is oppositely directed to the magnetization 113.

In another embodiment, the pinning structure 118 includes a pair of magnet structures separated by an antiferromagnetic coupling layer.

Figure 1C illustrates cross-sectional view of the pinning structure 118, in an accordance of an embodiment of the present disclosure. pinning structure 118 includes a magnet structure 118D having a magnetization 120A above a magnet structure 118E having a magnetization 120B, separated by a coupling layer 118F. In the illustrative embodiment, the magnetization 120A is oppositely directed to magnetization 120B, where magnetization 120B is of greater magnitude than magnetization 120A. In an embodiment, magnet structures 118D and 118E each include a stack of bilayers 119 capped by a layer of magnetic material 118C as discussed in association with Figure 1B. For example, magnet structure 118D may include a Co/Pt bilayer, where the number of bilayers is between 2-6 and capped by magnetic material such as cobalt. The magnet structure 118E may include a Co/Pt bilayer, where the number of bilayers is between 6-10 and is capped by magnetic material such as cobalt.

In an embodiment, the coupling layer 118F includes ruthenium or iridium. In an embodiment, coupling layer 118F includes ruthenium and has a thickness between 0.3nm and 1.0 nm to provide anti-ferromagnetic coupling between the magnet structure 118D and magnet structure 118E.

Referring again to Figure 1A, MTJ 104 further includes a coupling layer 121 between the pinning structure 118 and the magnetic structure 106. Depending on the pinning structure embodiment (Figure 1B and 1C), the coupling layer 121 includes a material that provides either ferromagnetic coupling or anti-ferromagnetic coupling between the pinning structure 118 and the fixed magnetic structure 118. When the coupling layer 121 includes tantalum or tungsten, coupling layer 121 provides ferromagnetic coupling. When the coupling layer 121 includes ruthenium or iridium, coupling layer 121 provides ferromagnetic coupling.

In an embodiment, coupling layer 121 is an anti-ferromagnetic coupling layer when MTJ 104 includes the pinning structure 118 described in Figure 1B. In one such embodiment, the pinning structure 118, described in Figure 1B, is anti-ferromagnetically coupled with the fixed magnetic structure 106 (illustrated in Figure 1A). In another embodiment, coupling layer 121 is a ferromagnetic coupling layer when MTJ 104 includes the pinning structure 118 described in Figure 1C. In one such embodiment, the magnet structure 118D in the pinning structure 118, described in Figure 1C, is ferromagnetically coupled with the fixed magnetic structure 106 (illustrated in Figure 1A).

In various embodiments, the MTJ 104 is above an electrode 101 that includes a material, having a cubic <001> crystal texture, for example TiN. Such a bottom electrode may offer ease in integrability of MTJ devices connected to peripheral devices such as transistors, for example. However, such an electrode 101 may present a surface that is incompatible for growth of layers in the pinning structure 118 having an FCC<111> crystal texture. It may be advantageous to have one or more intermediate layer above the bottom electrode, that has a crystal texture which promotes high quality FCC <111> crystal texture in the pinning structure and subsequently in the fixed magnetic layer. An intermediate layer that promotes a high-quality FCC <111> crystal texture in fixed magnetic layer can enhance perpendicular magnetic anisotropy (PMA) of the fixed magnetic layer.

In an embodiment, the memory device 100 includes a conductive layer 122 above the electrode 101 and a seed layer 124 on the conductive layer 122. In one example, the conductive layer 122 includes TaN, Ta, W, Ru. In another embodiment, the conductive layer 122 includes multilayers including or alloys of TaN, Ta, W, Ru. In such an example, the second conductive layer 122 may be predominantly tungsten. In some such examples, the conductive layer 122 can have a thickness between 0.1nm and 3nm. In other embodiments, the conductive layer 122 may have a graded concentration of tungsten, where the percent of tungsten decreases from a lower most surface 122A to an uppermost surface 122B. In some such embodiments the lower most portions of the conductive layer 122 is between 35% and 40% tungsten. In other examples, the conductive layer 122 has a composition that is no more than 50% tungsten and a balance that is substantially ruthenium. In some such embodiments, the conductive layer 122 has a thickness that is less than 2nm.

The seed layer 124, may set a crystalline template for the lower most magnetic layer in the pinning structure (during a fabrication process). In an embodiment, the seed layer 124 has an FCC <111> crystal texture. An example seed layer 124, that may be applicable for a Co/Pt multilayer above the seed layer 124, includes a metal such as platinum. In one such embodiment, the platinum seed layer 124 has an FCC <111> crystal texture. When the seed layer 124 includes Pt, the Pt seed layer 124 has a thickness in the range of 0.2nm - 5nm.

The MTJ 104 further includes a capping structure 126 on the free magnet 116. Capping structure 126 provides interfacial protection against iron or oxygen diffusion. In an embodiment, the capping structure 126 includes one or more layers to increase perpendicular magnetic anisotropy. For example, capping structure 126 may include a dielectric layer (including Mg and O) in contact with the free magnet 116 and a conductive layer (including CoFeB, Ta, Ru or W) on the dielectric layer. In other embodiments. Capping structure includes Ta, Ru or W. Capping structure 126 may range in thickness from 1.5nm to 3nm.

In an embodiment, the electrode 102 is in direct contact with the capping structure 126. includes one or more Ta, TaN or TiN. In an embodiment, the electrode 102 has a thickness between 5nm and 70nm. In some embodiments, the electrode 101 includes one or more layers including materials such as but not limited to TaN, W, Ru or TiN.

As shown the memory device 100 is above a substrate 128. The substrate 128 may include a suitable semiconductor material such as but not limited to, single crystal silicon, polycrystalline silicon and silicon on insulator (SOI). In another embodiment, substrate 128 includes other semiconductor materials such as germanium, silicon germanium or a suitable group III-N or a group III-V compound. Logic devices such as MOSFET transistors and access transistors and may be formed on the substrate 128 in one or more planes below the memory device 100. Logic devices such as access transistors may be integrated with memory devices such as memory device 100 to form embedded memory. Embedded memory including memory devices 100 and logic MOSFET transistors can be combined to form functional integrated circuit such as a system on chip.

Memory device 100 includes a fixed magnetic structure having two magnets. The fixed magnetic structure 106 may also include for example at least three magnets, where at least one of the magnets is a cobalt-tungsten alloy. In some such examples, cobalt tungsten alloy is not directly adjacent to the tunnel barrier.

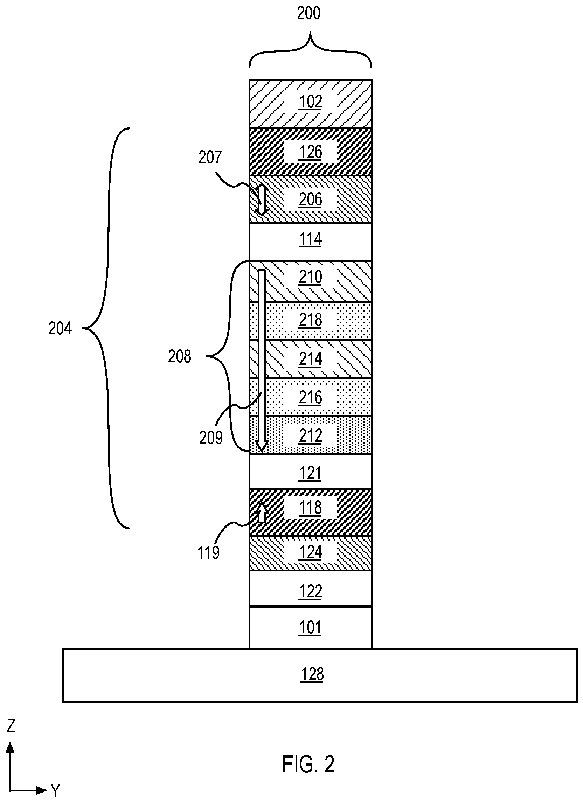

Figure 2 is an illustration of a cross-sectional view of a memory device 200 where the magnet structure 106 includes three magnets. As shown, memory device 200 includes the electrode 101, an electrode 102 above the electrode 101, and a magnetic tunnel junction (MTJ) 204 between the electrode 101 and the electrode 102. The MTJ 204 includes a first magnetic structure 206 having a free magnetization 207, and a second magnetic structure 208 below the first magnetic structure 206. The first magnetic structure 206 has a free magnetization 207 and may be referred to as free magnetic structure 206. The second magnetic structure 208 has a fixed magnetization 209 and may be referred to as fixed magnetic structure 208. The fixed magnetic structure 208 includes a first magnet 210, a second magnet 212 and a third magnet 214 between the first magnet 210 and second magnet 212, as shown.

The second magnetic structure 208 further includes a layer 216 between the magnet 214 and the magnet 212 and a layer 218 between the magnet 214 and the magnet 212.

In an embodiment, at least one of the magnets 212 or 214 includes cobalt and tungsten. In a first embodiment, magnet 214 includes cobalt and tungsten and magnet 212 includes a material that is the same or substantially the same as magnet 110. In a second embodiment, magnet 212 includes cobalt and tungsten and magnet 214 includes a material that is the same or substantially the same as magnet 110. In the first and second embodiments, magnet 210 includes a material that is the same or substantially the same as magnet 110. Magnet 210 does not include cobalt and tungsten mixture. In an embodiment, magnet 210, includes cobalt, iron and boron.

In some examples, magnet 210 includes cobalt, iron and boron and magnet 214 includes cobalt and tungsten. In such examples, the magnet 212 includes a material that is different from a material of magnet 210. Similarly, in other examples, magnet 210 includes cobalt, iron and boron and magnet 212 includes cobalt and tungsten. In such examples, the magnet 214 includes a material that is different from a material of magnet 210

In an embodiment, the layer 216 and layer 218 each include a material that is the same or substantially the same as the material of spacer layer 112.

In one or more embodiments, free magnetic structure 206 includes a layer of magnetic material that is the same or substantially the same as the material of magnet 116.

Memory device 200 includes one or more structural embodiments of the memory device 100. For example, memory device 200 includes substrate 128, electrode 101, conductive layer 122, seed layer 124, magnetic structure 118, coupling layer 121 adjacent to magnetic structure 208, tunnel barrier 114 on magnetic structure 208, capping structure 126 and electrode 102

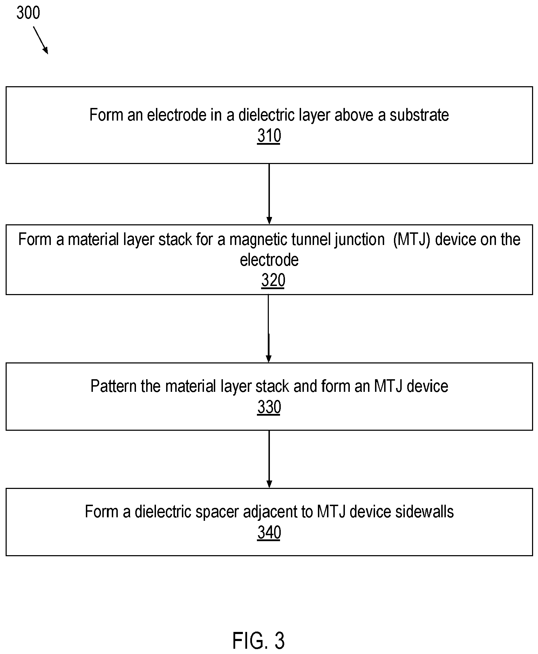

Figure 3 illustrates a flow diagram of a method to fabricate a memory device such as the memory device 100. The method 300 begins at operation 310 by forming a bottom electrode above a conductive interconnect formed in a dielectric layer a substrate. The method continues at operation 320 with the formation of a seed layer having an FCC <111> crystal texture, formation of a pinning magnetic layer having an FCC <111> crystal texture on the seed layer and formation of remaining layers of an MTJ material layer stack. At operation 330, the method 300 involves patterning the material layer stack to form a memory device. The method concludes at operation 340 with formation of a dielectric spacer adjacent to sidewalls of the memory device.

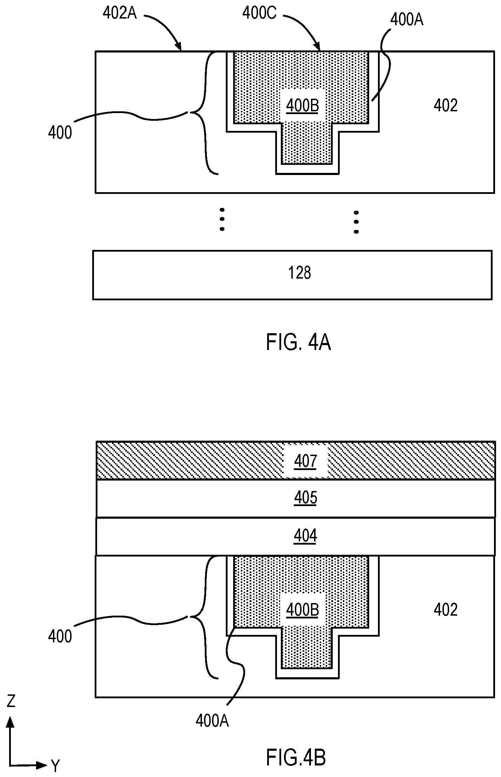

Figures 4A-4F illustrate cross-sectional views of the memory device 100 illustrated in Figure 1A evolving as a fabrication method, such as method 300, is practiced.

Figure 4A illustrates a conductive interconnect 400 formed above a substrate 128. In some embodiments, the conductive interconnect 400 is formed in a dielectric layer 402, above the substrate 128, as shown. In an embodiment, the conductive interconnects 400 includes a barrier layer 400A and a fill metal 400B. In some examples, the barrier layer 400A includes a material such as tantalum nitride or ruthenium. In some examples, the fill metal 400B includes a material such as cobalt, copper or tungsten. In other examples, the conductive interconnect 400 is fabricated using a subtractive etch process when materials other than copper are utilized. In an embodiment, the dielectric layer 402 includes silicon dioxide, silicon nitride, silicon carbide, or carbon doped silicon oxide. The dielectric layer 402 may have an uppermost surface 402A that is substantially co-planar with an uppermost surface 400C of the conductive interconnect 400, as is illustrated. In some embodiments, conductive interconnects 400 is electrically connected to a separate circuit element such as a transistor (not shown).

Figure 4B illustrates the structure of Figure 4A following the formation of an electrode layer 404 on the conductive interconnect 400 and on the uppermost surface 402A of the dielectric layer 402. In an embodiment, the electrode layer 404 includes a material that is the same or substantially the same as the material of the electrode 101. The electrode layer 404 may be deposited by a physical vapor deposition (PVD), chemical vapor deposition (CVD) or an atomic layer deposition process (ALD) process.

A conductive layer 405 is formed on the electrode layer 404. In an embodiment, the conductive layer 405 is formed by reactively co-sputtering tungsten and ruthenium onto the electrode layer 404. Depending on the material composition desired, the atomic percent of tungsten and ruthenium can be controlled during the deposition process. The atomic percent of tungsten and ruthenium can be varied during the deposition process to create an alloy having a gradient within the constituents of the alloy.

In a second embodiment, conductive layer 405 is formed by a deposition process where a thin layer of Ru is deposited onto a thin layer of tungsten, and where the deposition process is continued until a plurality of alternating layers of W and Ru are formed. The resulting material layer stack can be annealed to diffuse and intermix the W and the Ru forming the conductive layer 405. In some such embodiments, the layer of tungsten is between 0.05nm and 1nm, and the layer of ruthenium is between 0.05nm and 1nm.

In a third embodiment, conductive layer 405 is formed by sputtering an alloyed material from a Ru-W alloy target. In an embodiment, each Ru-W alloy target may have a particular relative atomic percent of W and Ru. In some embodiments, multiple Ru-W alloy targets each with different relative atomic percent of W and Ru may be utilized to deposit a plurality of alloy layers.

In one or more embodiments, deposition of the conductive layer 405 may begin by first depositing a layer of predominantly tungsten and then forming conductive layer 405 on the layer of predominantly tungsten. In some such embodiments, the deposition process further includes depositing a layer of ruthenium on the conductive layer 405, where the ruthenium has a thickness less than 0.5nm. In or more of the embodiments, the conductive layer 405 has a thickness between 0.5nm and 10nm.

A seed layer 407 is formed on the conductive layer 405. In an embodiment, as discussed above, the alloying of W and Ru changes the crystallographic texture of the conductive layer 405, compared to a layer of predominantly Ru or predominantly W. The crystallographic texture of the conductive layer 405 may enable a seed layer to be grown with an FCC <111> crystal texture with reduced strain mismatch compared to when a seed layer is grown on an underlying layer that does not include an alloy of tungsten and ruthenium. In an embodiment, the seed layer includes platinum having an FCC <111> crystal orientation. In other embodiments, the seed layer includes, Pd, W, or Mo. The seed layer may be deposited to a thickness between 0.2nm-1nm.

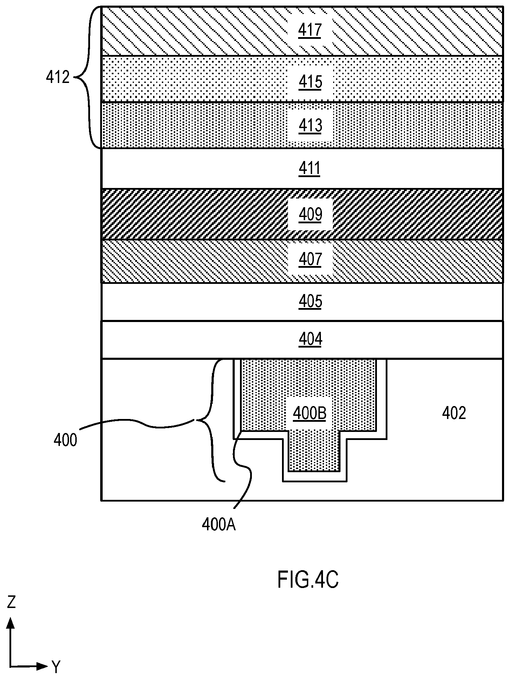

Figure 4C illustrates a cross-sectional view of the structure in Figure 4B following the formation of layers in pinning structure 409. In an embodiment, a plurality of layers in pinning structure 409 are deposited on the seed layer 407. In some embodiments, layers in pinning structure 409 are blanket deposited on the seed layer 407 using a PVD process. In some embodiments, the layers in pinning structure 409 are the same or substantially the same as the layers in pinning structure 118, described above. In an embodiment, the seed layer 407 has an FCC <111> crystal texture that enables lattice matching with a lowermost magnetic material in the layers in pinning structure 409. Such lattice matching enables formation of a fixed magnetic structure with strong perpendicular magnetic anisotropy above the layers in pinning structure 409. Furthermore, a seed layer 407 grown with reduced strain mismatch enables the lowermost layer in pinning structure 409 to be grown with an increased perpendicular anisotropy as measured by an increase in thermal stability.

A coupling layer 411 is formed on an uppermost layer in pinning structure 409. The coupling layer includes a material that is the same or substantially the same as the coupling layer 121. The thickness of the coupling layer is controlled to provide interlayer coupling between a pinning structure and a fixed magnetic structure to be formed.

The deposition process continues with formation of layers in a fixed magnetic structure 412 on the coupling layer 411. In an embodiment, a layer of cobalt and tungsten is co-sputter deposited on the surface of the coupling layer 411 to form magnetic layer 413. The deposition process may be carried out using a PVD tool. In an embodiment, an atomic percent of tungsten desired is controlled during deposition process to provide a uniform film. In other embodiments, the atomic percent of tungsten may be gradually decreased to form a gradient in tungsten composition. In an embodiment, tungsten does not exceed 20 atomic percent in the magnetic layer 413. The magnetic layer 413 can be annealed to diffuse and intermix the cobalt and tungsten. A tungsten and cobalt film form a magnetic layer 413 that breaks the FCC <111> symmetry propagated from the seed layer 407. In one example, magnetic layer 413 is deposited to a thickness between 0.8nm and 1.0nm.

A ferromagnetic coupling layer 415 is deposited on the magnetic layer 413. In an embodiment, the ferromagnetic coupling layer 415 includes a material that is the same or substantially the same as the material of the layer 112.

In an embodiment, a magnetic layer 417 is deposited on the ferromagnetic coupling layer 415. The magnetic layer 417 may be deposited using a PVD process or a PECVD process. The magnetic layer 417 includes a material that is the same or substantially the same as the material of the magnetic layer 110. The magnetic layer 417 includes a material that can be lattice matched with a tunnel barrier layer to be formed above. In one example, magnetic layer 417 is deposited to a thickness between 0.8nm and 1.0nm. In some embodiments, a thin layer of cobalt is deposited directly on the ferromagnetic coupling layer 415, followed by a blanket deposition of a layer including Ta, W, or Mo. A magnetic material such as material for magnet 116 may be deposited on the layer including Ta, W, or Mo.

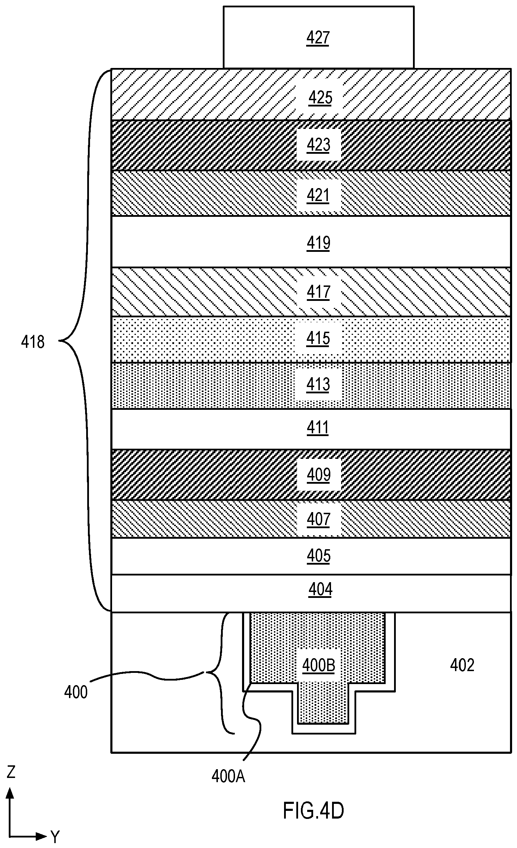

Figure 4D illustrates a cross-sectional view of the structure in Figure 4C following the formation of layers in a material layer stack 418 for a memory device.

In some embodiments, a tunnel barrier layer 419 is blanket deposited on magnetic layer 417. In an embodiment, the tunnel barrier layer 419 is a material including magnesium and oxygen (for e.g., MgO) or a material including aluminum and oxygen (for e.g., Al₂O₃). In an exemplary embodiment, the tunnel barrier layer 419 includes layer of MgO and is deposited using a reactive sputter process. In an embodiment, the reactive sputter process is carried out at room temperature. In another embodiment, the reactive sputter process is carried out at a temperature between 25-350 degrees Celsius. In an embodiment, the tunnel barrier layer 419 is deposited to a thickness between 0.8nm to 1nm. In some examples, the deposition process is carried out in a manner that yields a tunnel barrier layer 419 having an amorphous structure. In some such examples, the amorphous tunnel barrier layer 419 becomes crystalline after performing a high temperature anneal process to be described further below. In other embodiments, the tunnel barrier layer 419 is crystalline as deposited.

In an embodiment, a free magnetic layer 421 is blanket deposited on an uppermost surface of the tunnel barrier layer 419. In an embodiment, the deposition process includes a physical vapor deposition (PVD) or a plasma enhanced chemical vapor deposition process. In an embodiment, the PVD deposition process includes an RF or a DC sputtering process. In an exemplary embodiment, the free magnetic layer 421 is Co_{100-x-y}FeₓB_{y}, where X and Y each represent atomic percent, further where X is between 50-80 and Y is between 10-40, and further where the sum of X and Y is less than 100. In some embodiments, the free magnetic layer 421 includes a material that is the same or substantially the same as the material of the free magnet 116 described above. In some examples, the free magnetic layer 421 may be deposited to a thickness between 0.9nm and 2.0nm. A thickness range between 0.9nm and 2.0nm may be sufficiently thin to provide perpendicular magnetic anisotropy required to fabricate a perpendicular MTJ.

In an embodiment, one or more layers in a capping structure 423 are blanket deposited on the surface of the free magnetic layer 421. In an embodiment, the one or more layers in a capping structure 423 include one or more materials described in association with layers in capping structure 120. The one or more layers in capping structure 423 may be deposited using a variety of processes depending on the layers.

The deposition process concludes with the formation of a second electrode layer 425 on the one or more layers in capping structure 423. The electrode layer 425 includes a suitable material to provide a hardmask for etching the material layer stack 418. In an embodiment, the electrode layer 425 includes one or more layers of material such as Ta, TaN or TiN. In an embodiment, the thickness of the electrode layer 425 ranges from 40nm -70nm.

In an embodiment, after all the layers in the material layer stack 418 are deposited, an anneal is performed. In an embodiment, the anneal process enables formation of a crystalline alloy of one or more of Co, Fe or B in the magnetic layer 417 and free magnetic layer 421. In an embodiment, the anneal is performed immediately post deposition but before forming the mask 427 on the electrode layer 425. A post-deposition anneal of the material layer stack 418 is carried out in a furnace at a temperature between 300-450 degrees Celsius in a vacuum environment. In an embodiment, the annealing process promotes solid phase epitaxy of the magnetic layer 417 to follow a crystalline template of the adjacent tunnel barrier layer 419 (e.g., MgO). In an embodiment, the anneal also promotes solid phase epitaxy of the free magnetic layer 421 to follow a crystalline template of the adjacent tunnel barrier layer 419 (e.g., MgO) <001> Lattice matching between the tunnel barrier layer 419 and the free magnetic layer 421 and <001> lattice matching between the tunnel barrier layer 419 and the free magnetic layer 417 enables a TMR ratio of at least 100% to be obtained in the material layer stack 418.

In an embodiment, the mask 427 defines a shape and size of a memory device and a location where the memory device is to be subsequently formed with respect the conductive interconnect 400. In some embodiments, the mask 427 is formed by a lithographic process. In other embodiments, the mask 427 includes a dielectric material that has been patterned.

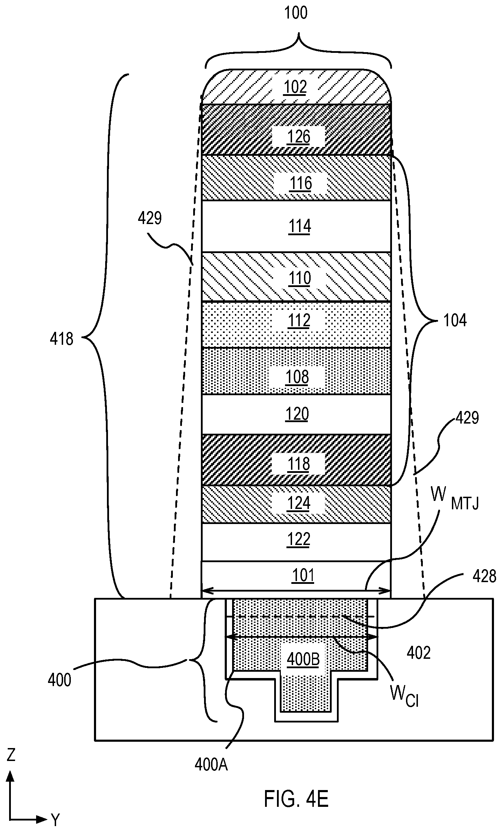

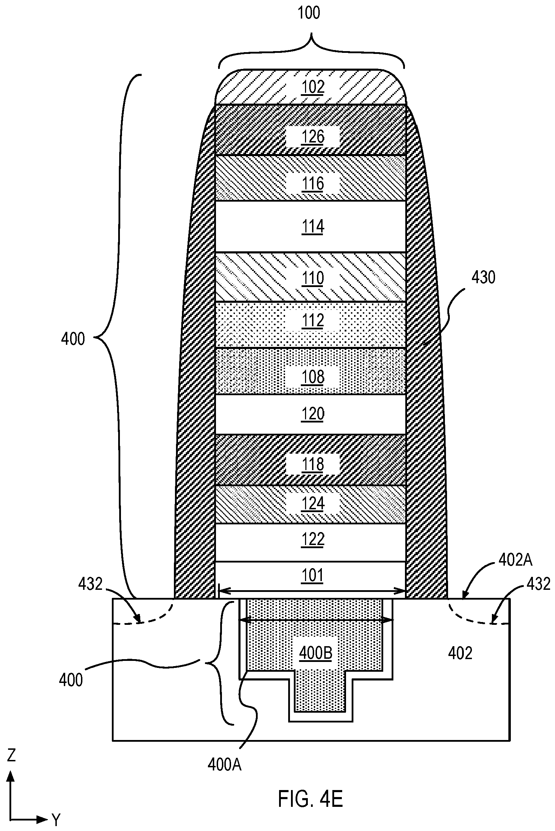

Figure 4E illustrates a cross-sectional view of the structure in Figure 4D following the patterning of the material layer stack 418. In an embodiment, the patterning process includes etching the electrode layer 425 by a plasma etch process to form top electrode 102.

In an embodiment, the plasma etch process is continued to pattern the layers of the material layer stack 418 to form a memory device 100. The various layers in the material layer stack 418 are etched to form a capping structure 126, free magnet 116, tunnel barrier 114, fixed magnet 110, spacer layer 112, fixed magnet 108, coupling layer 121, pinning structure 118, seed layer 124, conductive layer 122 and bottom electrode 101.

In an embodiment, the memory device 100 has a width, W_{MTJ}, that is greater than a width Wci of the conductive interconnect 400, as shown. In one such embodiment, the plasma etch process exposes the dielectric layer 402, when the memory device 100 is formed.

In an embodiment, where the memory device has a width, W_{MTJ}, that is less than a width W_{CI} of the conductive interconnect 400 the plasma etch process exposes portions of the conductive interconnect 400. In such an embodiment, the bottom electrode may include a cap across a top portion (above dashed line 428). A cap across the top portion prevents exposure of the liner layer 400A and the fill metal 400B. A cap may be highly desirable when the fill metal 400B is copper.

In some embodiments, depending on the etch parameters, and thickness of the various magnetic layers, the memory device 100 may have sidewalls that are tapered as indicated by the dashed lines 429. In some examples, there may be a recess in the dielectric 402 after formation of the memory device 100. The memory device 100 formed over the bottom electrode 101, constitutes a memory device with a perpendicular magnetic tunnel junction (pMTJ) 104.

Figure 4F illustrates a cross-sectional view of the structure in Figure 4E following the formation of a dielectric spacer 430 adjacent to the memory device 100. In an embodiment, a dielectric spacer layer is deposited on the memory device 100 and on the uppermost surface 402A of the dielectric layer 402. In an embodiment, the dielectric spacer layer is deposited without a vacuum break following the plasma etch process to prevent oxidation of magnetic layers in the pMTJ 104. In an embodiment, the dielectric spacer layer includes silicon and one or more of nitrogen or carbon. Absence of oxygen in the spacer layer may help minimize potential oxidation of magnetic layers. In an embodiment, the dielectric spacer layer is etched by a plasma etch process forming dielectric spacer 430 on sidewalls of the memory device 100. In some embodiments, the dielectric spacer 430 includes materials that are similar or substantially similar to the dielectric 402. In such embodiments, portions of the dielectric 402 may be recessed as indicated by dashed lines 432.

The structure of Figure 4F including the dielectric spacer 430 on sidewalls of the memory device 100 is herein referred to as memory device 400.

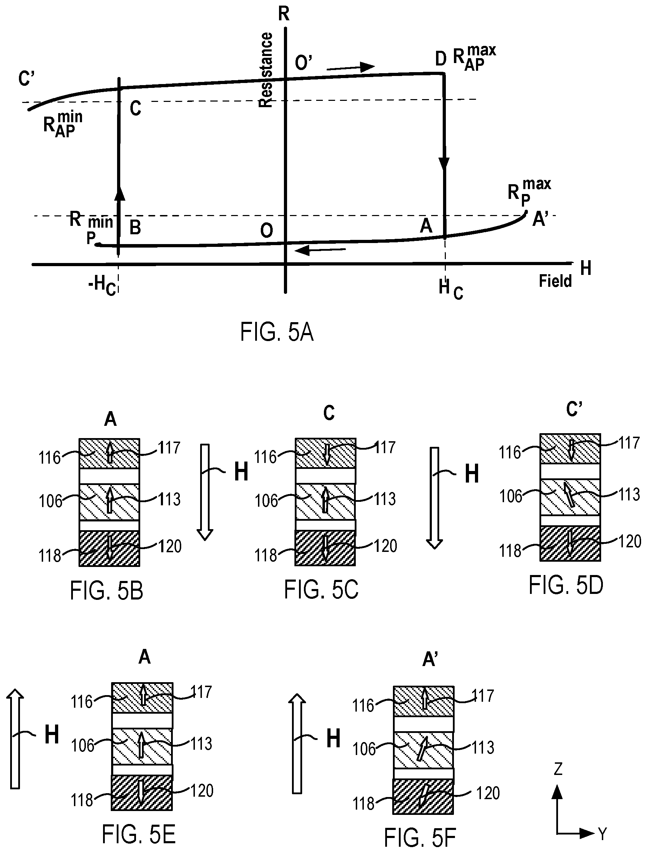

Figure 5A illustrates a plot of electrical resistance in a memory device (such as a memory device 100 depicted in Figure 1A) versus an externally applied magnetic field. The plot indicates a change in electrical resistance level in the memory device 100, as the field changes from point A to point B to point C to point D. Corresponding magnetization states in the pinning structure 118, in the fixed magnetic structure 106 and in the free magnet 116 are shown in Figures 5B-5F (other structural elements such as electrodes and capping structures are not illustrated for clarity).

In an embodiment, at point A, memory device 100 is in a low resistance state (Figure 5B). Referring to plot in Figure 5A, as the magnetic field is decreased to 0 at point "O" and then increased in the negative Z- direction, the resistance in memory device 100 increases from approximately Rₚ^{max} to approximately R_{AP}^{min} (read maximum Parallel resistance to minimum Anti-parallel resistance). There is gradual sloping in resistance in the plot from point A to point B and also between points C and D. However, there is a greater sloping in resistance for fields above +H_{C} and beyond -H_{C}. It is desirable to reduce resistance sloping within the box ABCD. A measure of the relative slope within box ABCD provides indication of the relative pinning between a pinning structure 118 and fixed magnetic structure 106.

As the field is increased in magnitude (in reverse direction) from point "O" towards point B, there is a resistance change at point B. The resistance in the memory device 100 increases (point C) due to a change in magnetization 121 in the free magnet 116 of the memory device 100. For a corresponding point C in the plot, the magnetization 121 in free magnet 116 is illustrated in Figure 5C. The magnetization 121 is antiparallel to magnetization 117 in the fixed magnetic structure 106 at point C.

Referring again to Figure 5A, if the magnetic field H continues to increase in the negative Z direction (point C to C'), the resistance in memory device 100 decreases relative resistance at point C, as shown in the plot. The resistance decreases from C to C' because the magnetic field may cant the magnetization 117 in the fixed magnetic structure 106 away from the positive Z direction as shown in Figure 5D.

Referring again to Figure 5A, as the magnitude of the applied magnetic field is reduced (Point C' to O') the resistance changes slightly as the fixed magnetic structure 106 is stably pinned to the pinning structure 118. When the applied magnetic field is increased in magnitude and directed towards the positive Z direction (Point O' to D), magnetization 121 in the free magnet 116 is influenced. In some embodiments, the resistance changes slightly from point O' to point D. The resistance at point D may be characterized by approximately R_{AP}^{max} (read maximum Parallel resistance).

At point D, at a critical magnetic field, H_{C}, there is a resistance change in the memory device 100 and the resistance drops to point A. From point D to point A, the magnetization 121 in the free magnet 116 changes from a configuration depicted in Figure 5C to a configuration depicted in Figure 5E. The magnetization 121 in the free magnet 116 aligns with the field and points in the positive Z direction as shown. However, if the applied magnetic field strength continues to increase (keeping the field direction the same), the maximum parallel resistance state in the memory device 100 will increase (at high field magnitude). The maximum parallel resistance (low resistance) starts to increase because increasing the magnetic field strength in a direction opposite to the magnetization 111 direction in the pinning structure 118 can cant the magnetization 107 in the pinning structure 118 as shown in Figure 5F. Canting in the magnetization 107 can influence the magnetization 117 in the fixed magnetic structure 106 because of magnetic coupling between the fixed magnetic structure 106 and the pinning structure 118. When the magnetization 117 is not completely parallel relative to magnetization 121 in free magnet 116, the maximum parallel resistance starts to increase.

The range between the externally applied field (in negative and positive directions) at which canting occurs provides an indication of how well pinned the fixed magnetic structure 106 is relative to the pinning structure 118. If the fixed magnetic structure 106 is not well pinned, canting can occur at lower magnitudes of the magnetic field.

In the plot illustrated in Figure 5A, the amount of sloping in the resistance levels between H_{C} and -H_{C} is less than 1 percent. In an embodiment, the shape of the R-H curve within H_{C} and - H_{C} is substantially flat and may be attributed to an iridium conductive layer and preservation of PMA in the pinning structure 118 and in the fixed magnetic structure 106 of the memory device 100. In an embodiment, a difference in resistance between O' and C' in a memory device 100 (including iridium conductive layer) is less compared to a memory device that includes a conductive layer having platinum for example. Similarly, in an embodiment, a difference in resistance between O' and A in a memory device 100 (including iridium conductive layer) is less compared to a memory device that includes a conductive layer having platinum example.

The inventors have found that an operating voltage needed to switch a pMTJ device 400 with a fixed magnetic structure 106 is lower compared to an operating voltage needed to switch a pMTJ device having a single fixed magnet that does not include cobalt-tungsten alloy.

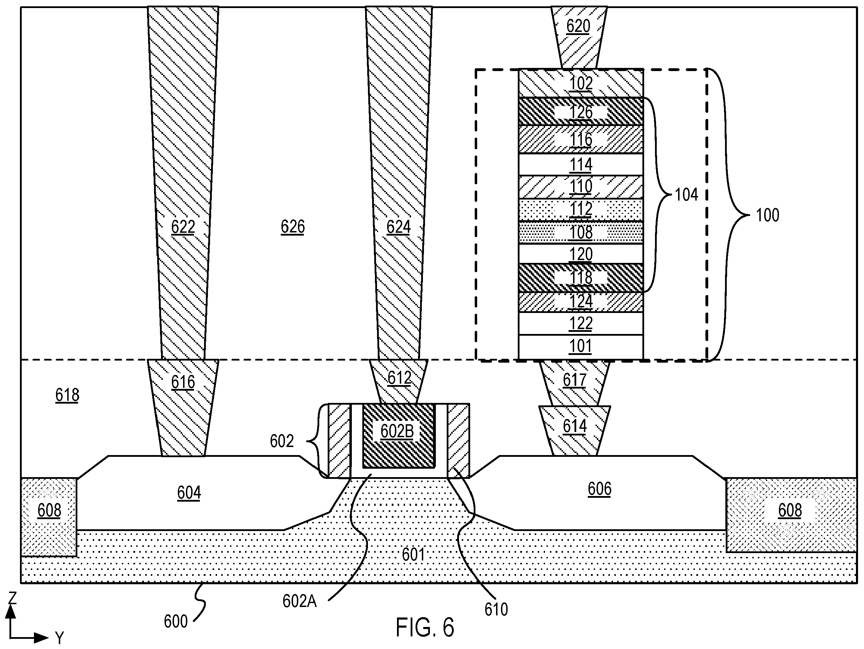

Figure 6 illustrates a memory device such as memory device 100 coupled to an access transistor 600. In an embodiment, the transistor 600 is on a substrate 601 and has a gate 602, a source region 604, and a drain region 606. In the illustrative embodiment, an isolation 608 is adjacent to the source region 604, drain region 606 and portions of the substrate 601. In some implementations of the disclosure, such as is shown, a pair of sidewall spacers 610 are on opposing sides of the gate 602.

The transistor 600 further includes a gate contact 612 above and electrically coupled to the gate 602, and a drain contact 614 above and electrically coupled to the drain region 606, and a source contact 616 above and electrically coupled to the source region 604, as is illustrated in Figure 6. The transistor 600 also includes dielectric 618 adjacent to the gate 602, source region 604, drain region 606, isolation 608, sidewall spacers 610, gate contact 612, drain contact 614 and source contact 616.

In an embodiment, the memory device 100 is a perpendicular memory device 100 with one or more structural and material properties described above in Figure 1A. The memory device 100 includes an electrode 101 , conductive layer 122 on the electrode 101, seed layer 124 on the conductive layer 122, a magnetic tunnel junction (MTJ) 104 on the seed layer 124, and an electrode 102 on the MTJ 104. MTJ 104 includes one or more properties of the MTJ 104 described in Figures 1A or Figure 2. In an embodiment, the MTJ 104 is a perpendicular MTJ 104.

An MTJ interconnect 620, is coupled with the electrode 102 as shown. MTJ interconnect 620 may be connected to one or more circuit elements. The memory device is above and coupled with conductive interconnect 617 and adjacent to dielectric 618.

In the illustrative embodiment, the conductive interconnect 617 is on and above with the drain contact 614. In the illustrative embodiment, one portion of the electrode 101 is in electrical contact with a drain contact 614 of transistor 600 through the conductive interconnect 617. In other embodiments, there are one or more additional interconnect structures between drain contact 614 and conductive interconnect 617.

In other embodiments, a perpendicular memory device having one or more features of memory device 200 (described in Figure 2) may be coupled with the transistor 600.

Gate contact 612 and source contact 616 are each coupled with interconnects. In the illustrative embodiment, gate contact 612 is coupled with a source interconnect 622 and the source contact 616 is coupled with a gate interconnect 624. A dielectric 626 is adjacent to source interconnect 622, gate interconnect 624, memory device 100, source contact 616 and gate contact 612.

In an embodiment, the underlying substrate 601 represents a surface used to manufacture integrated circuits. Suitable substrate 601 includes a material such as single crystal silicon, polycrystalline silicon and silicon on insulator (SOI), as well as substrates formed of other semiconductor materials. In some embodiments, the substrate 601 is the same as or substantially the same as the substrate 128. The substrate 601 may also include semiconductor materials, metals, dielectrics, dopants, and other materials commonly found in semiconductor substrates.

In an embodiment, the transistor 600 associated with substrate 601 are metal-oxide-semiconductor field-effect transistors (MOSFET or simply MOS transistors), fabricated on the substrate 601. In some embodiments, the transistor 600 is an access transistor 600. In various implementations of the disclosure, the transistor 600 may be planar transistors, nonplanar transistors, or a combination of both. Nonplanar transistors include FinFET transistors such as double-gate transistors and tri-gate transistors, and wrap-around or all-around gate transistors such as nanori16on and nanowire transistors.

In some embodiments, gate 602 includes at least two layers, a gate dielectric layer 602A and a gate electrode 602B. The gate dielectric layer 602A may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer 602A to improve its quality when a high-k material is used.

The gate electrode 602B of the access transistor 600 of substrate 601 is formed on the gate dielectric layer 602A and may consist of at least one P-type work function metal or N-type work function metal, depending on whether the transistor is to be a PMOS or an NMOS transistor. In some implementations, the gate electrode 602B may consist of a stack of two or more metal layers, where one or more metal layers are work function metal layers and at least one metal layer is a conductive fill layer.

For a PMOS transistor, metals that may be used for the gate electrode 602B include, but are not limited to, ruthenium, palladium, platinum, cobalt, nickel, and conductive metal oxides, e.g., ruthenium oxide. A P-type metal layer will enable the formation of a PMOS gate electrode with a work function that is between about 4.6 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a work function that is between about 3.6 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode 602B may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode 602B may consist of one or more U-shaped metal layers formed atop one or more planar, non-U-shaped layers.

The sidewall spacers 610 may be formed from a material such as silicon nitride, silicon oxide, silicon carbide, silicon nitride doped with carbon, and silicon oxynitride. Processes for forming sidewall spacers include deposition and etching process operations. In an alternate implementation, a plurality of spacer pairs may be used, for instance, two pairs, three pairs, or four pairs of sidewall spacers may be formed on opposing sides of the gate stack. As shown, the source region 604 and drain region 606 are formed within the substrate adjacent to the gate stack of each MOS transistor. The source region 604 and drain region 606 are generally formed using either an implantation/diffusion process or an etching/deposition process. In the former process, dopants such as boron, aluminum, antimony, phosphorous, or arsenic may be ion-implanted into the substrate to form the source region 604 and drain region 606. An annealing process that activates the dopants and causes them to diffuse further into the substrate typically follows the ion implantation process. In the latter process, the substrate 601 may first be etched to form recesses at the locations of the source and drain regions. An epitaxial deposition process may then be carried out to fill the recesses with material that is used to fabricate the source region 604 and drain region 606. In some implementations, the source region 604 and drain region 606 may be fabricated using a silicon alloy such as silicon germanium or silicon carbide. In some implementations, the epitaxially deposited silicon alloy may be doped in situ with dopants such as boron, arsenic, or phosphorous. In further embodiments, the source region 604 and drain region 606 may be formed using one or more alternate semiconductor materials such as germanium or a group III-V material or alloy. And in further embodiments, one or more layers of metal and/or metal alloys may be used to form the source region 604 and drain region 606.

In an embodiment, the source contact 616, the drain contact 614 and gate contact 612 each include a multi-layer stack. In an embodiment, the multi-layer stack includes two or more distinct layers of metal such as a layer of Ti, Ru or Al and a conductive cap on the layer of metal. The conductive cap may include a material such as W or Cu.

In an embodiment, the source interconnect 622 gate interconnect 624, conductive interconnect 617 and MTJ interconnect 620 includes a material that is the same or substantially the same as the material of the conductive interconnect 400 described in association with Figures 4A-4E.

The isolation 608 and dielectric 618 and 626 may each include any material that has sufficient dielectric strength to provide electrical isolation. Materials may include silicon and one or more of oxygen, nitrogen or carbon such as silicon dioxide, silicon nitride, silicon oxynitride, carbon doped nitride or carbon doped oxide.

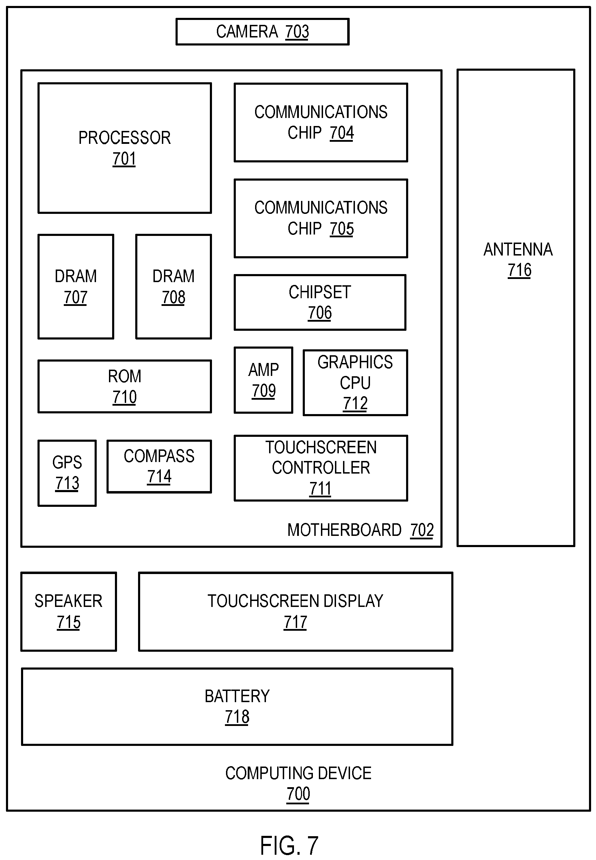

Figure 7 illustrates a computing device 700 in accordance with embodiments of the present disclosure. As shown, computing device 700 houses a motherboard 702. Motherboard 702 may include a number of components, including but not limited to a processor 701 and at least one communications chip 704 or 705. Processor 701 is physically and electrically coupled to the motherboard 702. In some implementations, communications chip 705 is also physically and electrically coupled to motherboard 702. In further implementations, communications chip 705 is part of processor 701.

Depending on its applications, computing device 700 may include other components that may or may not be physically and electrically coupled to motherboard 702. These other components include, but are not limited to, volatile memory (e.g., DRAM), non-volatile memory (e.g., ROM), flash memory, a graphics processor, a digital signal processor, a crypto processor, a chipset 706, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

Communications chip 705 enables wireless communications for the transfer of data to and from computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communications chip 705 may implement any of a number of wireless standards or protocols, including but not limited to Wi-Fi (IEEE 802.11 family), WiMAX (IEEE 802.11 family), long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Computing device 700 may include a plurality of communications chips 704 and 705. For instance, a first communications chip 705 may be dedicated to shorter range wireless communications such as Wi-Fi and Bluetooth and a second communications chip 704 may be dedicated to longer range wireless communications such as GPS, EDGE, GPRS, CDMA, WiMAX, LTE, Ev-DO, and others.

Processor 701 of the computing device 700 includes an integrated circuit die packaged within processor 701. In some embodiments, the integrated circuit die of processor 701 includes one or more transistors, interconnect structures, and non-volatile memory devices such as transistor 600, source interconnect 622, gate interconnect 624, MTJ interconnect 620 and conductive interconnect 617 and memory device 100, respectively (described in Figure 6). The term "processor" may refer to any device or portion of a device that processes electronic data from registers and/or memory to transform that electronic data into other electronic data that may be stored in registers and/or memory.

Communications chip 705 also includes an integrated circuit die packaged within communication chip 705. In another embodiment, the integrated circuit die of communications chips 704, 705 includes one or more transistors, interconnect structures, and non-volatile memory devices such as transistor 600, source interconnect 622, gate interconnect 624, MTJ interconnect 620 and conductive interconnect 400 and memory device 100, respectively (described in Figure 6). Depending on its applications, computing device 700 may include other components that may or may not be physically and electrically coupled to motherboard 702. These other components may include, but are not limited to, volatile memory (e.g., DRAM) 707, 708, non-volatile memory (e.g., ROM) 710, a graphics CPU 712, flash memory, global positioning system (GPS) device 713, compass 714, a chipset 706, an antenna 716, a power amplifier 709, a touchscreen controller 711, a touchscreen display 717, a speaker 715, a camera 703, and a battery 718, as illustrated, and other components such as a digital signal processor, a crypto processor, an audio codec, a video codec, an accelerometer, a gyroscope, and a mass storage device (such as hard disk drive, solid state drive (SSD), compact disk (CD), digital versatile disk (DVD), and so forth), or the like. In further embodiments, any component housed within computing device 700 and discussed above may contain a stand-alone integrated circuit memory die that includes one or more arrays of NVM devices including one or more memory devices 100 coupled with transistor 600 (described in Figure 6).

In various implementations, the computing device 700 may be a laptop, a netbook, a notebook, an Ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

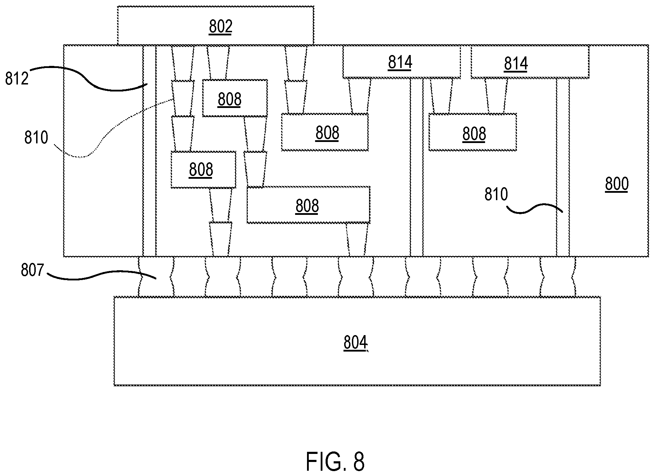

Figure 8 illustrates an integrated circuit (IC) structure 800 that includes one or more embodiments of the disclosure. The integrated circuit (IC) structure 800 is an intervening substrate used to bridge a first substrate 802 to a second substrate 804. The first substrate 802 may be, for instance, an integrated circuit die. The second substrate 804 may be, for instance, a memory module, a computer mother, or another integrated circuit die. Generally, the purpose of an integrated circuit (IC) structure 800 is to spread a connection to a wider pitch or to reroute a connection to a different connection. For example, an integrated circuit (IC) structure 800 may couple an integrated circuit die to a ball grid array (BGA) 807 that can subsequently be coupled to the second substrate 804. In some embodiments, the first and second substrates 802/804 are attached to opposing sides of the integrated circuit (IC) structure 800. In other embodiments, the first and second substrates 802/804 are attached to the same side of the integrated circuit (IC) structure 800. And in further embodiments, three or more substrates are interconnected by way of the integrated circuit (IC) structure 800.

The integrated circuit (IC) structure 800 may be formed of an epoxy resin, a fiberglass-reinforced epoxy resin, a ceramic material, or a polymer material such as polyimide. In further implementations, the integrated circuit (IC) structure may be formed of alternate rigid or flexible materials that may include the same materials described above for use in a semiconductor substrate, such as silicon, germanium, and other group III-V and group IV materials.

The integrated circuit (IC) structure may include metal interconnects 808 and vias 810, including but not limited to through-silicon vias (TSVs) 812. The integrated circuit (IC) structure 800 may further include embedded devices 814, including both passive and active devices. Such embedded devices 814 include capacitors, decoupling capacitors, resistors, inductors, fuses, diodes, transformers, device structure including transistors, such as transistor 600 (described in Figure 6) coupled with a with one at least one nonvolatile memory device such as memory device 100 including fixed magnetic structure 106 having an alloy of cobalt and tungsten, in accordance with an embodiment of the present disclosure. The integrated circuit (IC) structure 800 may further include embedded devices 814 such as one or more resistive random-access devices, sensors, and electrostatic discharge (ESD) devices. More complex devices such as radio-frequency (RF) devices, power amplifiers, power management devices, antennas, arrays, sensors, and MEMS devices may also be formed on the integrated circuit (IC) structure 800. In accordance with embodiments of the present disclosure, apparatuses or processes disclosed herein may be used in the fabrication of integrated circuit (IC) structure 800.

Accordingly, one or more embodiments of the present disclosure relate generally to the fabrication of embedded microelectronic memory. The microelectronic memory may be non-volatile, wherein the memory can retain stored information even when not powered. One or more embodiments of the present disclosure relate to the fabrication of a magnetic memory device such as the memory device 100 including a fixed magnetic structure including a first fixed magnet including an alloy of cobalt tungsten and a second fixed magnet over the first fixed magnet. The memory device 100 may be used in an embedded non-volatile memory application.

Thus, embodiments of the present disclosure include magnetic memory devices and methods of fabrication.

In a first example, a memory device includes a first electrode, a second electrode and a magnetic junction between the first electrode and the second electrode. The magnetic junction includes a first magnetic structure including a first magnet including an alloy of cobalt and tungsten, the first magnet having a first magnetization and a second magnet having the first magnetization, wherein the second magnet is above the first magnet. The magnetic junction further includes a first layer between the first magnet and the second magnet, a second layer including a metal and oxygen, where the second layer is on the first magnetic structure. The magnetic junction further includes a third magnet having a second magnetization, where the third magnet is on the second layer. The magnetic junction further includes a second magnetic structure below the first magnetic structure and a third layer between the first magnetic structure and the second magnetic structure.

In second examples, for any of the first example, the first magnet includes a mixture where the mixture includes between 1 and 20 atomic percent of tungsten.

In third examples, for any of the first through second examples, the first magnet has a thickness between 0.8nm and 1nm, wherein the second magnet has a thickness between 0.8nm and 1nm, and wherein the first layer has a thickness between 0.3nm and 0.5nm.

In fourth examples, for any of the first through third examples, the second magnet includes cobalt, iron and boron where the first layer includes tantalum, tungsten or molybdenum.

In fifth examples, for any of the first through fourth examples, the third magnet includes cobalt, iron and boron where the second layer includes magnesium and oxygen.

In sixth examples, for any of the first through fifth examples, where the third magnet further includes between 1 and 5 atomic percent of Mo, Ta, W and Hf.

In seventh examples, for any of the first through sixth examples, the first magnetic structure further includes a fourth magnet on the first layer and a fourth layer between the fourth magnet and the second magnet.

In eighth examples, for any of the first through seventh examples, the fourth magnet includes cobalt, iron and boron, and wherein the fourth layer includes tantalum, tungsten and molybdenum.

In ninth examples, for any of the first through eighth examples, the second magnet structure includes a stack of bilayers, wherein each of the bilayers includes a fifth magnet having a third magnetization and a non-magnetic layer on the fifth magnet.

In tenth examples, for any of the first through ninth examples, the fifth magnet includes Co or Fe, and wherein the non-magnetic layer includes Pt.

In eleventh examples, for any of the first through tenth examples, further including a fifth layer above the first electrode, wherein the fifth layer has an FCC <111> crystal texture, wherein the fifth layer includes platinum, and wherein the fifth layer has a thickness between 0.2nm and 5nm.

In twelfth examples, for any of the first through eleventh examples, further including a non-magnetic structure between the fifth layer and the first electrode, wherein the non-magnetic structure includes one or more layers of TaN, Ta, W and Ru.

In a thirteenth example, a memory device includes a first electrode, a second electrode and a magnetic junction between the first electrode and the second electrode. The magnetic junction includes a first magnetic structure including free magnetization, a second magnetic structure including a fixed magnetization. The second magnetic structure includes at least three magnets where one of the three magnets includes cobalt, iron and boron, and where another of the three magnets includes a mixture of Co and W. The magnetic junction further includes a first layer including a metal and oxygen on the first magnetic structure, where the first layer is between the first magnetic structure and the second magnetic structure.

In fourteenth examples, for any of the thirteenth example, the memory device further includes a pinning structure between the first electrode and the second magnetic structure, a second layer between the pinning structure and the second magnetic structure. The second magnetic structure includes a first magnet adjacent to the first layer, where the first magnet includes cobalt, iron and boron, a second magnet below the first magnet and a third magnet between the first magnet and the second magnet.

In fifteenth examples, for any of the thirteenth through fourteenth examples, the second magnet includes cobalt and tungsten.

In sixteenth examples, for any of the thirteenth through fifteenth examples, the third magnet includes cobalt and tungsten, and wherein the second magnet includes cobalt, iron and boron.

In seventeenth examples, for any of the thirteenth through sixteenth examples, the second magnetic structure has a thickness less than 2.5 nm.

In eighteenth examples, for any of the thirteenth through seventeenth examples, the second magnet structure further includes a first non-magnetic conductive layer between the first magnet and the second magnet, a second non-magnetic conductive layer between the second magnet and the third magnet and a third non-magnetic conductive layer between the third magnet and the pinning structure.

In a nineteenth example, a system includes a processor including at least a transistor above a substrate where the transistor includes a drain contact coupled to a drain, a source contact coupled to a source and a gate contact coupled to a gate. The system further includes a memory device coupled with the drain contact, where the memory device includes a first electrode, a second electrode and a magnetic junction between the first electrode and the second electrode. The magnetic junction includes a first magnetic structure including a first magnet including an alloy of cobalt and tungsten, where the first magnet has a first magnetization and a second magnet having the first magnetization, where the second magnet is above the first magnet. The magnetic junction further includes a first layer between the first magnet and the second magnet, a second layer including a metal and oxygen, where the second layer is on the first magnetic structure above the first magnet structure, a third magnet having a second magnetization on the second layer, a second magnetic structure below the first magnetic structure and a third layer between the first magnetic structure and the second magnetic structure.

In twentieth examples, for any of the nineteenth example, the system further includes a battery coupled to power at least one of the processor or memory.

Examples include a method comprising: forming a first electrode; forming a second electrode; forming a magnetic junction between the first electrode and the second electrode, wherein forming the magnetic junction comprising: forming a first magnetic structure, wherein forming the first magnetic structure comprising: forming a first magnet comprising an alloy of cobalt and tungsten, the first magnet having a first magnetization; and forming a second magnet having the first magnetization, wherein the second magnet is above the first magnet; forming a first layer between the first magnet and the second magnet; forming a second layer comprising a metal and oxygen, wherein the second layer is on the first magnetic structure; forming a third magnet having a second magnetization, wherein the third magnet is on the second layer; forming a second magnetic structure below the first magnetic structure; and forming a third layer between the first magnetic structure and the second magnetic structure.

In some examples, the forming a first magnet comprises forming a mixture, and wherein the mixture comprises between 1 and 20 atomic percent of tungsten.

In some examples, the first magnet has a thickness between 0.8nm and 1nm.

In some examples, the second magnet has a thickness between 0.8nm and 1nm, and wherein the first layer has a thickness between 0.3nm and 0.5nm.

In some examples, the second magnet comprises cobalt, iron and boron, and wherein the first layer comprises tantalum, tungsten or molybdenum.

## Claims

1. A memory device, comprising:
a first electrode;
a second electrode;
a magnetic junction between the first electrode and the second electrode, the magnetic junction comprising:
a first magnetic structure comprising:
a first magnet comprising an alloy of cobalt and tungsten, the first magnet having a first magnetization; and
a second magnet having the first magnetization, wherein the second magnet is above the first magnet;
a first layer between the first magnet and the second magnet;
a second layer comprising a metal and oxygen, wherein the second layer is on the first magnetic structure;
a third magnet having a second magnetization, wherein the third magnet is on the second layer;
a second magnetic structure below the first magnetic structure; and
a third layer between the first magnetic structure and the second magnetic structure.

2. The memory device of claim 1, wherein the first magnet comprises a mixture, and wherein the mixture comprises between 1 and 20 atomic percent of tungsten.

3. The memory device of claim 1 or 2, wherein the first magnet has a thickness between 0.8nm and 1nm, wherein the second magnet has a thickness between 0.8nm and 1nm, and wherein the first layer has a thickness between 0.3nm and 0.5nm.

4. The memory device of any of claims 1 to 3, wherein the second magnet comprises cobalt, iron and boron, and wherein the first layer comprises tantalum, tungsten or molybdenum.

5. The memory device of any of claims 1 to 4, wherein the third magnet comprises cobalt, iron and boron, and wherein the second layer comprises magnesium and oxygen.

6. The memory device of any of claims 1 to 5, wherein the third magnet further comprises between 1 and 5 atomic percent of Mo, Ta, W and Hf.

7. The memory device of any of claims 1 to 6, wherein the first magnetic structure further comprises:
a fourth magnet on the first layer; and
a fourth layer between the fourth magnet and the second magnet.

8. The memory device of claim 7, wherein the fourth magnet comprises cobalt, iron and boron, and wherein the fourth layer comprises tantalum, tungsten and molybdenum.

9. The memory device of any of claims 1 to 8, wherein the second magnet structure comprises a stack of bilayers, wherein each of the bilayers comprises a fifth magnet having a third magnetization and a non-magnetic layer on the fifth magnet.

10. The memory device of claim 9, wherein the fifth magnet comprises Co or Fe, and wherein the non-magnetic layer comprises Pt.

11. The memory device of any of claims 1 to 10 further comprising a fifth layer above the first electrode, wherein the fifth layer has an FCC <111> crystal texture, wherein the fifth layer comprises platinum, and wherein the fifth layer has a thickness between 0.2nm and 5nm.

12. The memory device of claim 11 further comprising a non-magnetic structure between the fifth layer and the first electrode, wherein the non-magnetic structure comprises one or more layers of TaN, Ta, W and Ru.

13. A system comprising:
a processor comprising at least a transistor above a substrate, the transistor comprising:
a drain contact coupled to a drain;
a source contact coupled to a source; and
a gate contact coupled to a gate; and
a memory device coupled with the drain contact, the memory device according to any one of claims 1 to 12; and
a wireless interface to allow the processor to communicate with another device.

14. The system of claim 13, further comprising a battery coupled to power at least one of the processor or memory.

15. A method comprising:
forming a first electrode;
forming a second electrode;
forming a magnetic junction between the first electrode and the second electrode, whrein forming the magnetic junction comprising:
forming a first magnetic structure, wherein forming the first magnetic structure comprising:
forming a first magnet comprising an alloy of cobalt and tungsten, the first magnet having a first magnetization; and
forming a second magnet having the first magnetization, wherein the second magnet is above the first magnet;
forming a first layer between the first magnet and the second magnet;
forming a second layer comprising a metal and oxygen, wherein the second layer is on the first magnetic structure;
forming a third magnet having a second magnetization, wherein the third magnet is on the second layer;
forming a second magnetic structure below the first magnetic structure; and
forming a third layer between the first magnetic structure and the second magnetic structure.
